# EUROPEAN PATENT SPECIFICATION

(11) **EP 2 056 400 B1**
(45) Date of publication and mention of the grant of the patent: **31.08.2016**
(21) Application number: 08739091.0
(22) Date of filing: 27.03.2008
(51) Int. Cl.: H01Q 1/38, G06K 19/07, G06K 19/077, H01Q 1/50, H01Q 7/00, H01Q 23/00, H01Q 1/22

(54) **WIRELESS IC DEVICE AND ELECTRONIC DEVICE**
DRAHTLOSE IC-VORRICHTUNG UND ELEKTRONISCHE VORRICHTUNG
DISPOSITIF CI SANS FIL ET DISPOSITIF ELECTRONIQUE

(30) Priority: 18.07.2007 JP 2007186392; 08.02.2008 WO PCT/JP2008/052129
(43) Date of publication of application: 06.05.2009
(60) Divisional application: 15164716.1
(73) Proprietor: MURATA MANUFACTURING CO., LTD., Nagaokakyo-shi, Kyoto 617-8555 (JP)
(72) Inventor: KATAYA, Takeshi, Kyoto-fu 617-8555 (JP); KATO, Noboru, Kyoto-fu 617-8555 (JP); ISHINO, Satoshi, Kyoto-fu 617-8555 (JP); IKEMOTO, Nobuo, Kyoto-fu 617-8555 (JP); KIMURA, Ikuhei, Kyoto - fu 617-8555 (JP); DOKAI, Yuya, Kyoto-fu 617-8555 (JP)
(74) Representative: Zimmermann, Tankred Klaus
(86) International application number: PCT/JP2008/055962
(87) International publication number: WO 2009/011154

(56) References cited:
- EP-A1- 1 976 056
- EP-A1- 2 056 488
- EP-A1- 2 133 827
- EP-A1- 2 166 617
- EP-A1- 2 166 618
- WO-A1-2007/028379
- JP-A- 11 175 678
- JP-A- 2001 168 628
- JP-A- 2003 198 230
- JP-A- 2004 040 597
- JP-A- 2006 195 795
- JP-A- 2007 013 120
- JP-A- 2007 052 660
- US-A- 5 955 723
- US-A1- 2006 158 380

## Description

### Technical Field

The present invention relates to radio frequency IC devices, and, more particularly, to a radio frequency IC device including a radio frequency IC chip used for an RFID (Radio Frequency Identification) system and an electronic apparatus including the radio frequency IC device.

### Background Art

In recent years, as a product management system, an RFID system has been developed in which a reader/writer for generating an induction field communicates with an IC chip (hereinafter also referred to as an IC tag or a radio frequency IC chip) attached to a product or a case in a noncontact manner so as to obtain predetermined information stored in the IC chip.

Patent Document 1 discloses an RFID tag including an IC chip mounted on the main surface of a printed circuit board and an antenna formed in the printed circuit board. In this RFID tag, the antenna and the IC chip are electrically connected to each other. The miniaturization of the RFID tag is achieved by disposing the antenna in the printed circuit board.

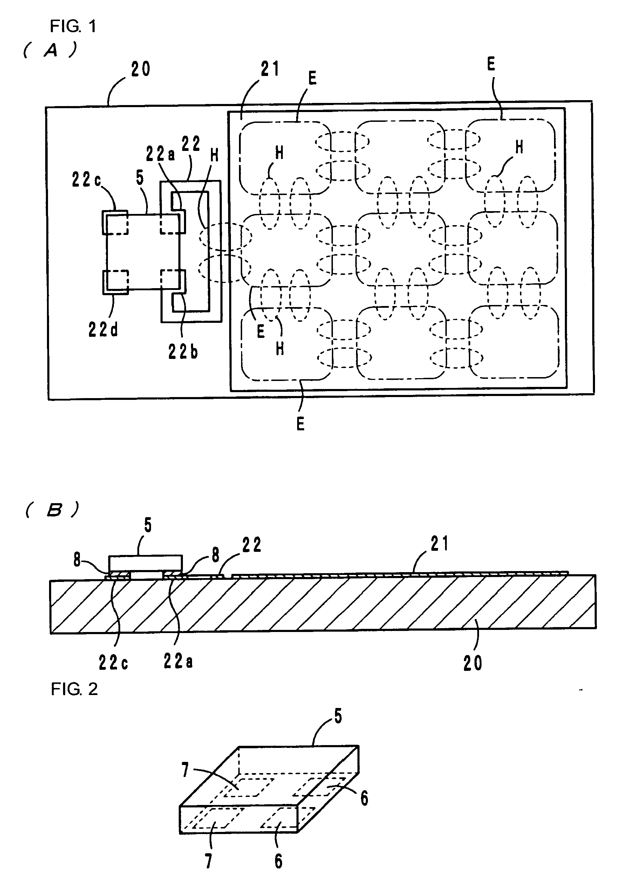

In the case of the RFID tag, however, the number of manufacturing processes is increased so as to prepare the dedicated antenna, and a space for the dedicated antenna is required. This leads to the increases in manufacturing cost and size of the RFID tag. As illustrated in Fig. 2 in

Patent Document 1, the number of manufacturing processes is increased especially if an antenna having a meander shape is formed, since internal electrodes included in a plurality of layers are required to be processed. Furthermore, in order to achieve the impedance matching between the IC chip and the antenna, a matching section is required. If the matching section is disposed between the antenna and the IC chip, the size of the antenna is increased. Furthermore, if the IC chip is changed, the shape of the antenna is also required to be changed.

Patent Document 1: Japanese Unexamined Patent Application Publication (Translation of PCT Application) No. 11-515094 EP 2166618 A1 forms prior art according to Article 54(3) EPÜ to the extent it is supported by JP2007176360 the priority of which it claims. EP 2166618 A1 discloses a wireless IC device that can be attached to a small article, and that suppresses the thickness of a tag forming portion. A cutout portion having no aluminum-deposited film is formed at an end of an article package made of an aluminum-deposited laminated film, and an electromagnetic coupling module is provided at that portion. The electromagnetic coupling module and the aluminum-deposited film of the package constitute a wireless IC device. A loop electrode, which is a magnetic field transmission auxiliary radiator of the electromagnetic coupling module, is coupled to the aluminum-deposited film of the package. Thus, the article package operates as a radiator of an antenna overall.

JP 2001168628 A discloses an IC card. A main coil having a sub coil is provided on an IC card main body including an antenna mounting type module for communication. The coil resonates with an operation frequency together with the coil, improves the transmission and reception sensitivities of the antenna of the module and can efficiently transmit a radio wave from the module to the outside.

### Disclosure of Invention

### Problems to be Solved by the Invention

It is an object of the present invention to provide a small radio frequency IC device capable of easily achieving impedance matching without using a dedicated antenna and an electronic apparatus including the radio frequency IC device.

### Means for Solving the Problems

This object is achieved by a radio frequency IC device according to claim 1.

This object is achieved by a radio frequency IC device according to claim 1 and 2.

In the radio frequency IC device, a radio frequency IC chip or a power supply circuit board is coupled to an electrode formed at a circuit board, for example, a ground electrode via a loop electrode. The electrode formed at the circuit board functions as a radiation plate (an antenna) for the radio frequency IC (chip). That is, the electrode receives a signal, and the radio frequency IC (chip) receives the signal from the electrode via the loop electrode and is operated by the received signal. A response signal output from the radio frequency IC (chip) is transmitted to the electrode via the loop electrode, and is then emitted from the electrode to the outside. Accordingly, a dedicated antenna is not necessarily required, and a space for the dedicated antenna is not required. The loop electrode can perform the impedance matching between the radio frequency IC (chip) and the electrode. Accordingly, a matching section is not necessarily required. The efficiency of signal transmission between the radio frequency IC (chip) and the electrode is therefore improved.

In a radio frequency IC device according to the second embodiment, a power supply circuit board is disposed between a radio frequency IC, for example, a radio frequency IC chip and a loop electrode. This power supply circuit board includes a resonance circuit including an inductance element and/or a matching circuit. A frequency used is practically set by the resonance circuit and/or the matching circuit. If the radio frequency IC is changed in accordance with a frequency used by an RFID system, only the change in design of the resonance circuit and/or the matching circuit is required. It is not required to change the shape, size, and position of a radiation plate (electrode) or the state of coupling between the loop electrode and the electrode or the power supply circuit board. The resonance circuit and/or the matching circuit can also have a function of achieving the impedance matching between the radio frequency IC and the electrode. Accordingly, the efficiency of signal transmission between the radio frequency IC and the electrode can be improved.

In the radio frequency IC device, the loop electrode coupled to the radio frequency IC (chip) or the power supply circuit board may be formed on a plurality of layers included in a multilayer circuit board.

The radio frequency IC (chip) stores various pieces of information about a product to which the radio frequency IC device is attached, and, furthermore, may be a rewritable radio frequency IC (chip). That is, the radio frequency IC (chip) may have an information processing function in addition to a function for an RFID system.

### Advantages

According to the present invention, an existing electrode included in a circuit board can be used as an antenna. Since a dedicated antenna is not necessarily required, a radio frequency IC device and an apparatus including the radio frequency IC device can be miniaturized. A resonance circuit and/or a matching circuit included in a loop electrode and/or a power supply circuit board can have an impedance matching function. Accordingly, a matching section is not necessarily required.

### Brief Description of Drawings

Fig. 1(A) is a plan view of a radio frequency IC device according to a first embodiment of the present invention.
Fig. 1(B) is a cross-sectional view in a lengthwise direction of the radio frequency IC device according to the first embodiment of the present invention.
Fig. 2 is a perspective view of a radio frequency IC chip.
Fig. 3(A) is a plan view of a radio frequency IC device according to a second embodiment of the present invention.
Fig. 3(B) is a cross-sectional view in a lengthwise direction of the radio frequency IC device according to the second embodiment of the present invention.
Fig. 4(A) is a plan view of a radio frequency IC device according to a third embodiment of the present invention.
Fig. 4(B) is a cross-sectional view in a lengthwise direction of the radio frequency IC device according to the third embodiment of the present invention.
Fig. 4(C) is a cross-sectional view in a widthwise direction of the radio frequency IC device according to the third embodiment of the present invention.
Fig. 5(A) is a plan view of a radio frequency IC device according to a fourth embodiment of the present invention.
Fig. 5(B) is a cross-sectional view in a lengthwise direction of the radio frequency IC device according to the fourth embodiment of the present invention.
Fig. 6(A) is a plan view of a radio frequency IC device according to a fifth embodiment of the present invention.
Fig. 6(B) is a cross-sectional view in a lengthwise direction of the radio frequency IC device according to the fifth embodiment of the present invention.
Fig. 6(C) is a cross-sectional view in a widthwise direction of the radio frequency IC device according to the fifth embodiment of the present invention.
Fig. 7(A) is a plan view of a radio frequency IC device according to a sixth embodiment of the present invention.
Fig. 7(B) is a cross-sectional view in a lengthwise direction of the radio frequency IC device according to the sixth embodiment of the present invention.
Fig. 8(A) is a plan view of a radio frequency IC device according to a seventh embodiment of the present invention.
Fig. 8(B) is a cross-sectional view in a lengthwise direction of the radio frequency IC device according to the seventh embodiment of the present invention.
Fig. 9 is an exploded plan view of a circuit board of a radio frequency IC device according to an eighth embodiment of the present invention.
Fig. 10 is an exploded plan view of a circuit board of a radio frequency IC device according to a ninth embodiment of the present invention.
Fig. 11 is a plan view of a circuit board of a radio frequency IC device according to a tenth embodiment of the present invention.
Fig. 12 is a plan view illustrating a main part of a circuit board of a radio frequency IC device according to an eleventh embodiment of the present invention.
Fig. 13 is an exploded plan view of a circuit board of a radio frequency IC device according to a twelfth embodiment of the present invention.
Fig. 14 is an exploded plan view of a circuit board of a radio frequency IC device according to a thirteenth embodiment of the present invention.
Fig. 15 is an exploded perspective view of a power supply circuit board including a first exemplary resonance circuit.
Fig. 16 is a plan view of a power supply circuit board including a second exemplary resonance circuit.
Fig. 17 is a perspective view of a mobile telephone that is an electronic apparatus according to an embodiment of the present invention.
Fig. 18 is a diagram describing a printed circuit board included in the mobile telephone.

### Best Modes for Carrying Out the Invention

A radio frequency IC device and an electronic apparatus according to an embodiment of the present invention will be described below with reference to the accompanying drawings. In the drawings, the same numerals are used for like components and portions so as to avoid repeated explanation.

### (First Embodiment, See, Figs. 1 and 2)

Fig. 1 is a diagram illustrating a radio frequency IC device according to the first embodiment of the present invention. This radio frequency IC device includes a radio frequency IC chip 5 for processing a transmission/received signal of a predetermined frequency, a printed circuit board 20 on which the radio frequency IC chip 5 is mounted, and a ground electrode 21 and a loop electrode 22 which are formed on the printed circuit board 20. Each of the ground electrode 21 and the loop electrode 22 is formed on the main surface of the printed circuit board 20 by applying coating of conductive paste thereto or making metal foil on the printed circuit board 20 etched.

The radio frequency IC chip 5 includes a clock circuit, a logic circuit, and a memory circuit, and stores necessary information. As illustrated in Fig. 2, input-output terminal electrodes 6 and mounting terminal electrodes 7 are formed on the undersurface of the radio frequency IC chip 5. One of the input-output terminal electrodes 6 is electrically connected to a connection electrode 22a disposed at one end of the loop electrode 22 via a metal bump 8, and the other one of the input-output terminal electrodes 6 is electrically connected to a connection electrode 22b disposed at the other end of the loop electrode 22 via the metal bump 8. A pair of connection electrodes 22c and 22d is disposed on the printed circuit board 20. One of the mounting terminal electrodes 7 of the radio frequency IC chip 5 is connected to the connection electrode 22c via the metal bump 8, and the other one of the mounting terminal electrodes 7 is connected to the connection electrode 22d via the metal bump 8.

The loop electrode 22 is disposed near the edge of the ground electrode 21 in the horizontal direction, whereby the loop electrode 22 and the ground electrode 21 are coupled to each other by electric field coupling. That is, by disposing the loop electrode 22 near the ground electrode on the same surface, a loop magnetic field H (denoted by a dotted line in Fig. 1(A)) is generated from the loop electrode 22 in the vertical direction. The generated loop magnetic field H enters the ground electrode 21 at right angles, so that a loop electric field E (denoted by an alternate long and short dashed line in Fig. 1(A)) is excited. The loop electric field E induces another loop magnetic field H. Thus, the loop electric field E and the loop magnetic field H are generated on the entire surface of the ground electrode 21, so that a high-frequency signal is emitted into the air. As described previously, by disposing the ground electrode 21 and the loop electrode 22 close to each other on the same main surface while providing the electrical isolation between them, the electromagnetic field coupling between them can be achieved with certainty. Consequently, a radiation characteristic can be improved.

The electromagnetic coupling between the loop electrode 22 and the ground electrode 21 allows a high-frequency signal received by the ground electrode 21 from a reader/writer to be transmitted to the radio frequency IC chip 5 via the loop electrode 22 so as to activate the radio frequency IC chip 5, and allows a response signal output from the radio frequency IC chip 5 to be transmitted to the ground electrode 21 via the loop electrode 22 and then be emitted from the ground electrode 21 toward the reader-writer.

As the ground electrode 21, an existing component included in the printed circuit board 20 of an electronic apparatus containing the radio frequency IC device may be used. Alternatively, a ground electrode used for another electronic component included in an electronic apparatus may be used as the ground electrode 21. Accordingly, in this radio frequency IC device, a dedicated antenna is not required, and the space for the antenna is not therefore required. Furthermore, since the ground electrode 21 of large size is used, a radiation characteristic can be improved.

By controlling the length and width of the loop electrode 22 and the space between the loop electrode 22 and the ground electrode 21, the impedance matching between the radio frequency IC chip 5 and the ground electrode 21 can be achieved.

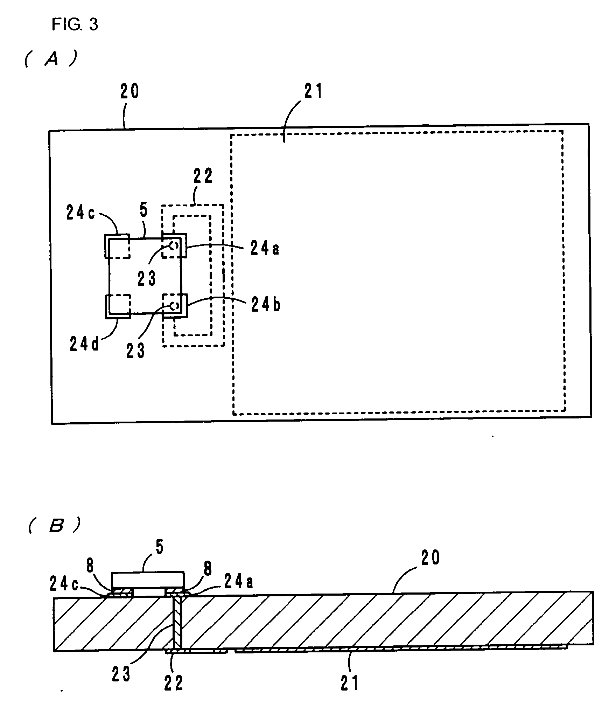

### (Second Embodiment, See Fig. 3)

Fig. 3 is a diagram illustrating a radio frequency IC device according to the second embodiment of the present invention. This radio frequency IC device is basically identical to a radio frequency IC device according to the first embodiment. The ground electrode 21 and the loop electrode 22 are formed on the undersurface of the printed circuit board 20. Connection electrodes 24a to 24d are formed on the surface of the printed circuit board 20. The connection electrodes 24a and 24b are electrically connected through a via-hole conductor 23 to one end of the loop electrode 22 and the other end of the loop electrode 22, respectively. The connection electrodes 24a to 24d correspond to the connection electrodes 22a to 22d illustrated in Fig. 1, respectively. One of the input-output terminal electrodes 6 (see, Fig. 2) is electrically connected to the connection electrode 24a via the metal bump 8, and the other one of the input-output terminal electrodes 6 is electrically connected to the connection electrode 24b via the metal bump 8. One of the mounting terminal electrodes 7 (see, Fig. 2) is connected to the connection electrode 24c via the metal bump 8, and the other one of the mounting terminal electrodes 7 is connected to the connection electrode 24d via the metal bump 8.

The ground electrode 21 and the loop electrode 22 are coupled in the same manner as that described in the first embodiment. The operational effect of a radio frequency IC device according to the second embodiment is the same as that of a radio frequency IC device according to the first embodiment. In this embodiment, a large space for another electronic component can be obtained on the surface of the circuit board 20.

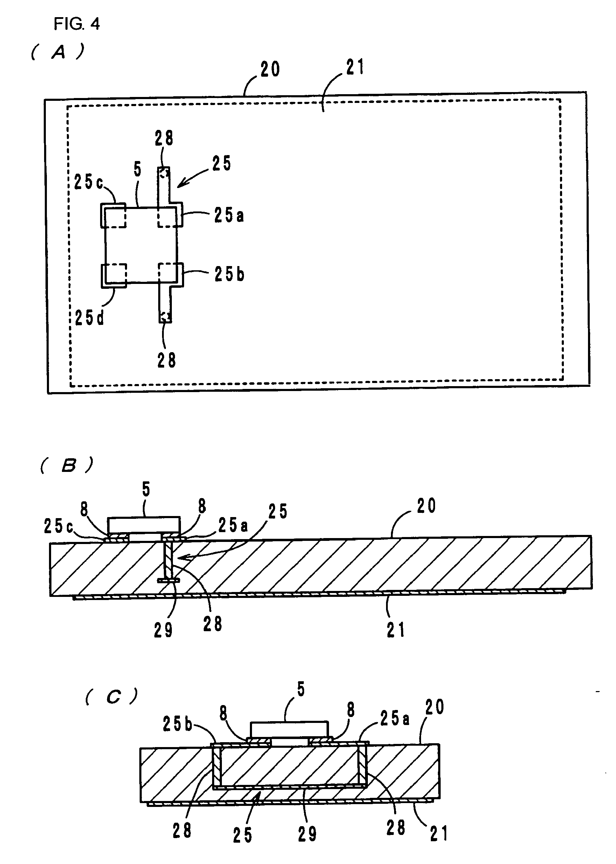

### (Third Embodiment, See Fig. 4)

Fig. 4 is a diagram illustrating a radio frequency IC device according to the third embodiment of the present invention. In this radio frequency IC device, a loop electrode 25 includes connection electrodes 25a and 25b disposed on the surface of the printed circuit board 20, via-hole conductors 28, and an internal electrode 29. The loop electrode 25 is coupled to the ground electrode 21 formed on the undersurface of the printed circuit board 20 by electric field coupling. The connection electrodes 25a and 25b are electrically connected via the metal bump 8 to one of the terminal electrodes 6 (see, Fig. 2) and the other one of the terminal electrodes 6, respectively. Connection electrodes 25c and 25d are electrically connected via the metal bump 8 to one of the terminal electrodes 7 (see, Fig. 2) and the other one of the terminal electrodes 7, respectively.

The loop electrode 25 is disposed near the ground electrode 21 in the vertical direction, and is coupled to the ground electrode 21 by electric field coupling. That is, a magnetic flux is generated from the loop electrode 25 near the surface on which the ground electrode 21 is formed, and an electric field that intersects the magnetic field at right angles is generated from the ground electrode 21. As a result, an electric field loop is excited on the ground electrode 21. The excited electric field loop generates a magnetic field loop. Thus, the electric field loop and the magnetic field loop are generated on the entire surface of the ground electrode 21, so that a high-frequency signal is emitted into the air. That is, by disposing the loop electrode 25 near the ground electrode 21 in the vertical direction while providing the electric isolation between the loop electrode 25 and the ground electrode 21, the flexibility in placing the loop electrode 25 (that is, the radio frequency IC chip 5) can be increased.

The operation and operational effect of a radio frequency IC device according to the third embodiment are basically the same as those of a radio frequency IC device according to the first embodiment. In this embodiment, since the loop electrode 25 is formed in the printed circuit board 20, interference caused by the penetration of a magnetic field from the outside can be prevented. The ground electrode 21 may be formed in the printed circuit board 20. In this case, since a large empty space can be obtained on the main surface and undersurface of the printed circuit board 20, another line or another electronic component may be disposed thereon so as to increase the packing density.

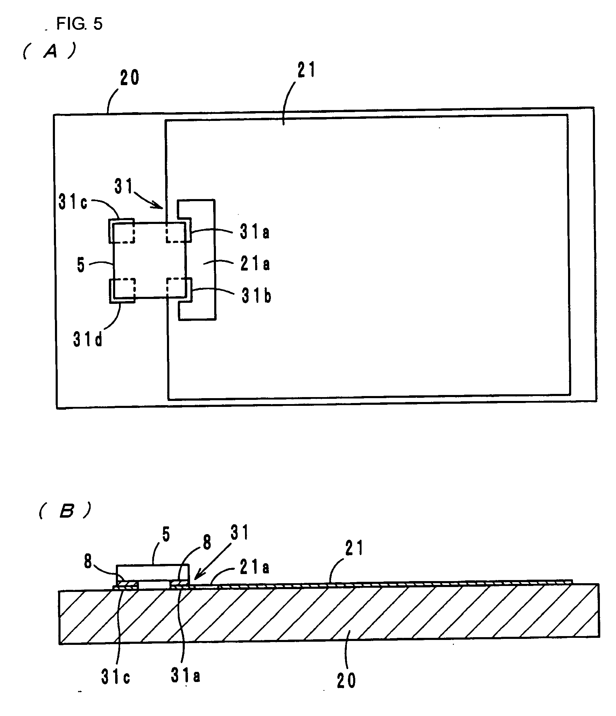

### (Fourth Embodiment, See, Fig. 5)

Fig. 5 is a diagram illustrating a radio frequency IC device according to the fourth embodiment of the present invention. This radio frequency IC device includes a loop electrode 31 obtained by forming a cutout 21a at one side of the ground electrode 21 disposed on the surface of the printed circuit board 20. Connection electrodes 31a and 31b are electrically connected via the metal bump 8 to one of the input-output terminal electrodes 6 (see, Fig. 2) and the other one of the input-output terminal electrodes 6, respectively. Connection electrodes 31c and 31d formed on the surface of the printed circuit board 20 are electrically connected via the metal bump 8 to one of the mounting terminal electrodes 7 (see, Fig. 2) and the other one of the mounting terminal electrodes 7, respectively.

In the fourth embodiment, the loop electrode 31 is electrically coupled to the ground electrode 21. The radio frequency IC chip 5 is coupled to the ground electrode 21 via the loop electrode 31 disposed therebetween. The operation and operational effect of a radio frequency IC device according to the fourth embodiment are the same as those of a radio frequency IC device according to the first embodiment.

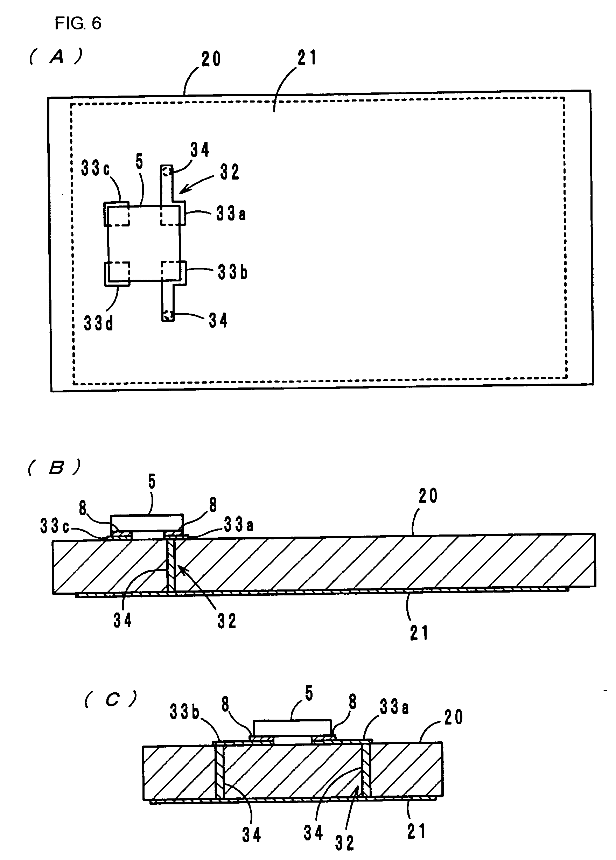

### (Fifth Embodiment, See, Fig. 6)

Fig. 6 is a diagram illustrating a radio frequency IC device according to the fifth embodiment of the present invention. Like a radio frequency IC device according to the fourth embodiment, in this radio frequency IC device, the ground electrode 21 is electrically coupled to a loop electrode 32. More specifically, the loop electrode 32 includes connection electrodes 33a and 33b disposed on the surface of the printed circuit board 20 and via-hole conductors 34. The ground electrode 21 is formed on the undersurface of the printed circuit board 20. The upper end of one of the via-hole conductors 34 is electrically connected to the connection electrode 33a, and the upper end of the other one of the via-hole conductors 34 is electrically connected to the connection electrode 33b. The lower ends of the via-hole conductors 34 are electrically connected to the ground electrode 21. The connection electrodes 33a and 33b are electrically connected via the metal bump 8 to one of the terminal electrodes 6 (see, Fig. 2) of the radio frequency IC chip 5 and the other one of the terminal electrodes 6, respectively. Connection electrodes 33c and 33d are electrically connected via the metal bump 8 to one of the terminal electrodes 7 (see, Fig. 2) of the radio frequency IC chip 5 and the other one of the terminal electrodes 7, respectively.

In the fifth embodiment, the loop electrode 32 is electrically coupled to the ground electrode 21. The radio frequency IC chip 5 and the ground electrode 21 are coupled to each other via the loop electrode 32 disposed therebetween. The operation and operational effect of a radio frequency IC device according to the fifth embodiment are the same as those of a radio frequency IC device according to the first embodiment.

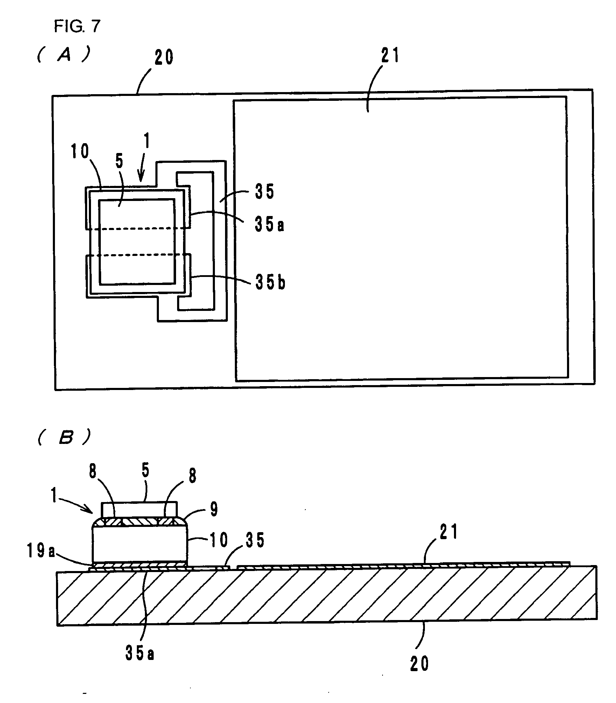

### (Sixth Embodiment, See, Fig. 7)

Fig. 7 is a diagram illustrating a radio frequency IC device according to the sixth embodiment of the present invention. In this radio frequency IC device, an electromagnetic coupling module 1 is formed by mounting the radio frequency IC chip 5 on a power supply circuit board 10. The electromagnetic coupling module 1 is electrically connected to a loop electrode 35 formed on the printed circuit board 20. Like the loop electrode 22 described in the first embodiment, the loop electrode 35 is disposed near the ground electrode 21 formed on the surface of the printed circuit board 20, whereby the loop electrode 35 and the ground electrode 21 are coupled to each other by magnetic field coupling.

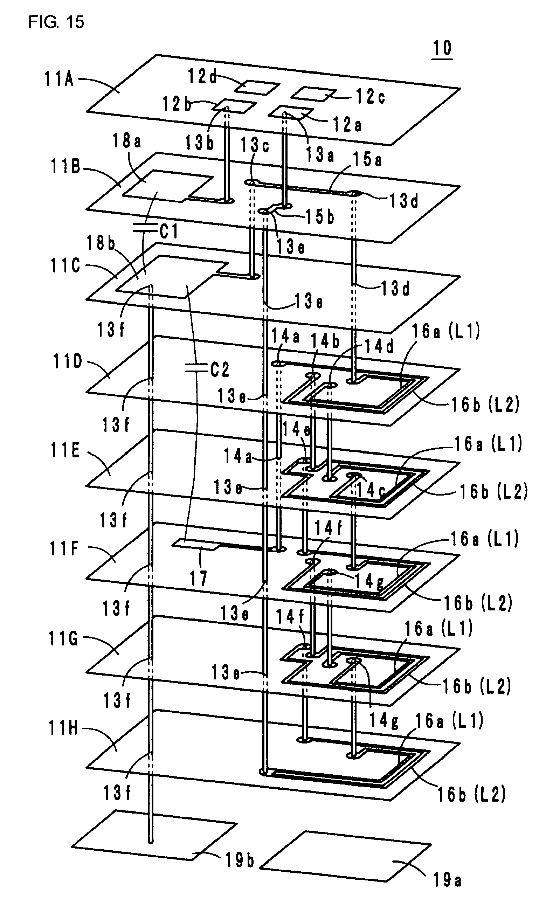

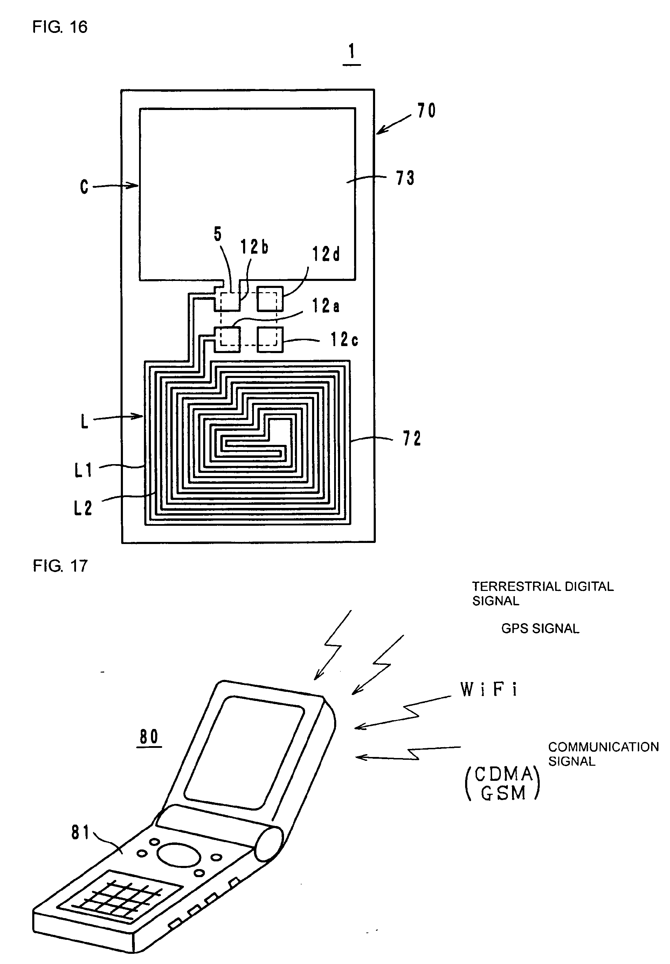

One of the input-output terminal electrodes 6 of the radio frequency IC chip 5, which are illustrated in Fig. 2, and the other one of the input-output terminal electrodes 6 are electrically connected via the metal bump 8 to electrodes 12a and 12b (see, Figs. 15 and 16) formed on the surface of the power supply circuit board 10, respectively. One of the mounting terminal electrodes 7 of the radio frequency IC chip 5 and the other one of mounting terminal electrodes 7 are electrically connected via the metal bump 8 to electrodes 12c and 12d, respectively. A protection film 9 is formed between the surface of the power supply circuit board 10 and the undersurface of the radio frequency IC chip 5 so as to improve the bonding strength between the power supply circuit board 10 and the radio frequency IC chip 5.

The power supply circuit board 10 includes a resonance circuit (not illustrated in Fig. 7) having an inductance element. Outer electrodes 19a and 19b (see, Figs. 15 and 16) are formed on the undersurface of the power supply circuit board 10, and the connection electrodes 12a to 12d (see, Figs. 15 and 16) are formed on the surface of the power supply circuit board 10. The outer electrodes 19a and 19b are electromagnetically coupled to the resonance circuit included in the power supply circuit board 10, and are electrically connected to connection electrodes 35a and 35b of the loop electrode 35, respectively, with an electroconductive adhesive (not illustrated). Such electrical connection may be established by soldering.

That is, the power supply circuit board 10 includes a resonance circuit having a predetermined resonance frequency so as to transmit a transmission signal of a predetermined frequency output from the radio frequency IC chip 5 to the ground electrode 21 via the outer electrodes 19a and 19b and the loop electrode 35, or select a received signal of a predetermined frequency from among signals received by the ground electrode 21 and supply the selected received signal to the radio frequency IC chip 5. Accordingly, in this radio frequency IC device, the radio frequency IC chip 5 is operated by a signal received by the ground electrode 21, and a response signal output from the radio frequency IC chip 5 is emitted to the outside from the ground electrode 21.

In the electromagnetic coupling module 1, the outer electrodes 19a and 19b formed on the undersurface of the power supply circuit board 10 are coupled to the resonance circuit included in the power supply circuit board 10 by electromagnetic field coupling, and is electrically connected to the loop electrode 35 that is coupled to the ground electrode 21 functioning as an antenna by electric field coupling. In this embodiment, since a relatively large antenna element is not required as another component, the electromagnetic coupling module 1 of small size can be obtained. Furthermore, the size of the power supply circuit board 10 is small. Accordingly, IC mounters that have been widely used can be used to mount the radio frequency IC chip 5 on the power supply circuit board 10 of small size. This leads to the reduction in the cost of mounting. When a frequency band used is changed, only the change in the design of the resonance circuit is required.

Only an inductance element may be used as an element formed in the power supply circuit board 10. The inductance element has a function of achieving the impedance matching between the radio frequency IC chip 5 and a radiation plate (the ground electrode 21).

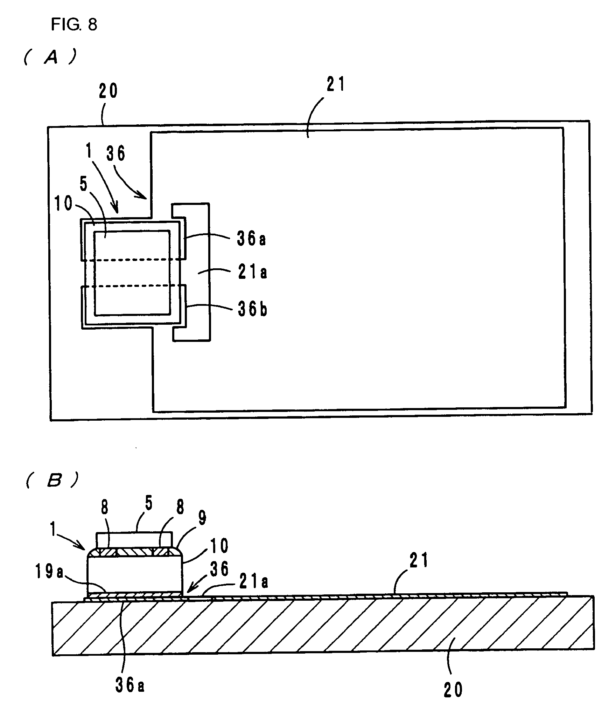

### (Seventh Embodiment, See, Fig. 8)

Fig. 8 is a diagram illustrating a radio frequency IC device according to the seventh embodiment of the present invention. Like a radio frequency IC device according to the sixth embodiment, in this radio frequency IC device, the electromagnetic coupling module 1 is formed by mounting the radio frequency IC chip 5 on the power supply circuit board 10. The electromagnetic coupling module 1 is electrically connected to a loop electrode 36 formed on the printed circuit board 20. Like the loop electrode 31 described in the fourth embodiment, the loop electrode 36 is obtained by forming the cutout 21a at one side of the ground electrode 21. Connection electrodes 36a and 36b are electrically connected to the outer electrodes 19a and 19b formed on the undersurface of the power supply circuit board 10, respectively, with a conductive adhesive (not illustrated). In the seventh embodiment, the structure and operation of the power supply circuit board 10 are the same as those described in the sixth embodiment, and the operation of the loop electrode 36 is the same as that described in the fourth embodiment.

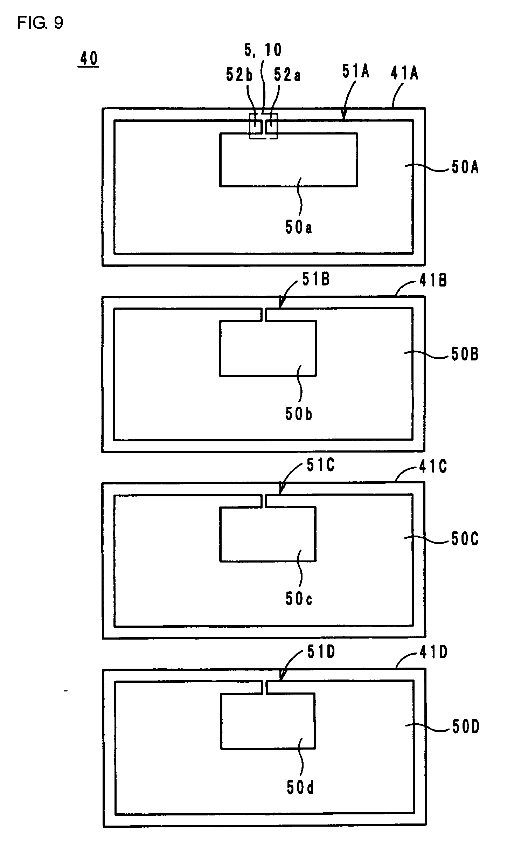

### (Eighth Embodiment, See Fig. 9)

Fig. 9 is an exploded view of a printed circuit board 40 included in a radio frequency IC device according to the eighth embodiment of the present invention. The printed circuit board 40 is a multilayer board in which a plurality of dielectric layers or magnetic layers are laminated. Loop electrodes 51A to 51D are formed on a first layer 41A serving as the surface of the printed circuit board 40, a second layer 41B, a third layer 41C, and a fourth layer 41D serving as the undersurface of the printed circuit board 40, respectively.

Like the loop electrode described in the fourth embodiment (see, Fig. 5), the loop electrodes 51A to 51D are obtained by forming cutouts 50a to 50d at ground electrodes 50A to 50D formed on the layers 41A to 41D, respectively. Connection electrodes 52a and 52b of the loop electrode 51A formed on the first layer 41A are electrically connected to one of the input-output terminal electrodes 6 of the radio frequency IC chip 5 and the other one of the input-output terminal electrodes 6, respectively, or are electromagnetically coupled to the power supply circuit board 10 (the electromagnetic coupling module 1). The ground electrodes 50A to 50D may be electrically connected to each other through via-hole conductors. An electrode functioning as an antenna may not necessarily be a ground electrode.

Referring to Fig. 1, the loop electrode 22 is used so as to cause the ground electrode 21 to function as an antenna, and the loop electrode 22 has an impedance conversion function. More specifically, the loop electrode 22 has an impedance between the connection electrodes 22a and 22b which is determined by the shape of the loop. A current corresponding to a signal transmitted from the radio frequency IC chip 5 or the power supply circuit board 10 coupled to the connection electrodes 22a and 22b flows along the loop.

The impedance (Z) between the connection electrodes 22a and 22b is represented by the sum of a real part and an imaginary part (X). The smaller the shape of the loop electrode 22, the shorter the length of a path for a current. The shorter the length of the path for a current, the lower a resistance generated at the loop electrode 22 and the impedance (X = ωL) of an inductance (L) generated by a current passing through the path. If a space for the loop electrode 22 becomes smaller in accordance with the miniaturization of an apparatus such as a mobile telephone, the impedance of the loop electrode 22 becomes a very low. This makes the large impedance difference between the loop electrode 22 and a radio frequency IC chip or a power supply (resonance/matching) circuit. Consequently, sufficient electric power cannot be supplied from the radio frequency IC chip 5 or the power supply circuit to a radiation plate.

In order to solve this problem, it is required to set a higher impedance (Z) for the loop electrode 22, that is, increase the real part or the imaginary part (X). The eighth to thirteenth embodiments solve such a problem. Accordingly, in the eighth embodiment, the ground electrode 50A functions as an antenna and provides the same operational effect as that described in the first embodiment. Furthermore, in the eighth embodiment, the size of the loop electrode 51A, which is formed on the first layer 41A and is coupled to the radio frequency IC chip 5 or the power supply circuit board 10, is larger than that of the other loop electrodes, that is, the loop electrodes 51B to 51D. Accordingly, a path for a current passing through the loop electrode 51A at the time of communication becomes longer, the resistance becomes higher, and the real part is increased. As a result, a higher impedance (Z) can be obtained.

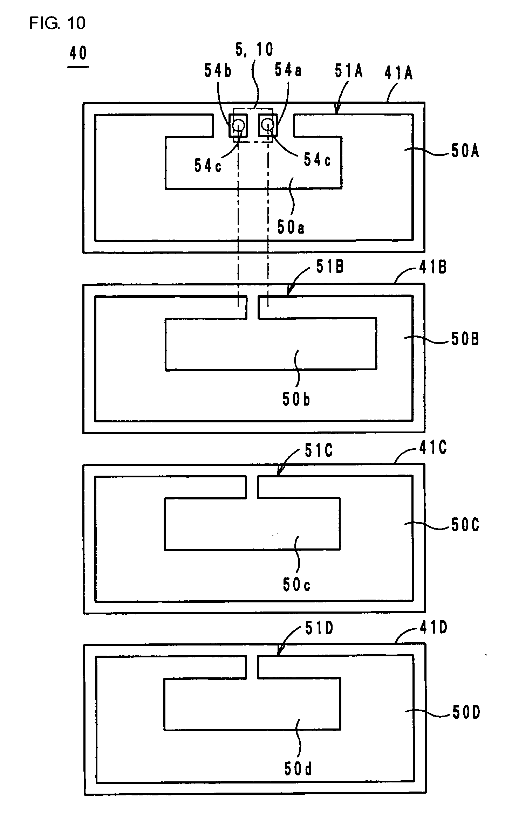

### (Ninth Embodiment, See, Fig. 10)

Fig. 10 is an exploded view of the printed circuit board 40 included in a radio frequency IC device according to the ninth embodiment of the present invention. An radio frequency IC device according to the ninth embodiment is basically identical to a radio frequency IC device according to the eighth embodiment except that connection electrodes 54a and 54b (formed on the first layer 41A) coupled to the radio frequency IC chip 5 or the power supply circuit board 10 are electrically connected to the loop electrode 51B formed on the second layer 41B through via-hole conductors 54c and the size of the loop electrode 51B is larger than that of the loop electrodes 51A, 51C, and 51D. Accordingly, the operational effect of a radio frequency IC device according to the ninth embodiment is the same as that of a radio frequency IC device according to the eighth embodiment.

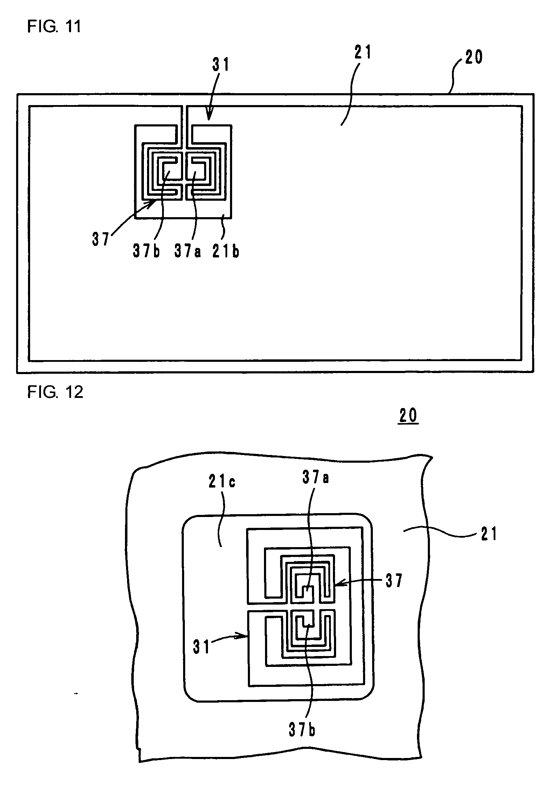

### (Tenth Embodiment, See, Fig. 11)

Fig. 11 is a diagram illustrating the printed circuit board 20 included in a radio frequency IC device according to the tenth embodiment of the present invention. A cutout 21b is formed at the ground electrode 21 formed on the surface of the printed circuit board 20. In the cutout 21b, the loop electrode 31 is formed. On the inner side of the loop electrode 31, a meander matching electrode 37 is disposed. Connection electrodes 37a and 37b that are the ends of the matching electrode 37 are coupled to the radio frequency IC chip 5 or the power supply circuit board 10.

Like the above-described embodiments, in the tenth embodiment, the ground electrode 21 functions as an antenna, and provides the same operational effect as that described in the first embodiment. The meander matching electrode 37 disposed on the inner side of the loop electrode 31 increases the length of a path for a current flowing through the loop electrode 31. The resistance and the real part are therefore increased. As a result, the impedance (Z) can be increased. The exemplary shape of the matching electrode 37 illustrated in Fig. 11 may be changed in accordance with the shape or size of the cutout 21b.

### (Eleventh Embodiment, See, Fig. 12)

Fig. 12 is a diagram illustrating the main part of the printed circuit board 20 included in a radio frequency IC device according to the eleventh embodiment of the present invention. A radio frequency IC device according to the eleventh embodiment is basically identical to a radio frequency IC device according to the tenth embodiment except that the loop electrode 31 including the meander matching electrode 37 on the inner side thereof is disposed in a cutout 21c of the ground electrode 21 and is coupled to the ground electrode 21 by electric field coupling in the same manner that described in the first embodiment.

Like the tenth embodiment, in this embodiment, the connection electrodes 37a and 37b which are the ends of the matching electrode 37 are coupled to the radio frequency IC chip 5 or the power supply circuit board 10. The ground electrode 21 functions as an antenna, and provides the same operational effect as that described in the first and tenth embodiments.

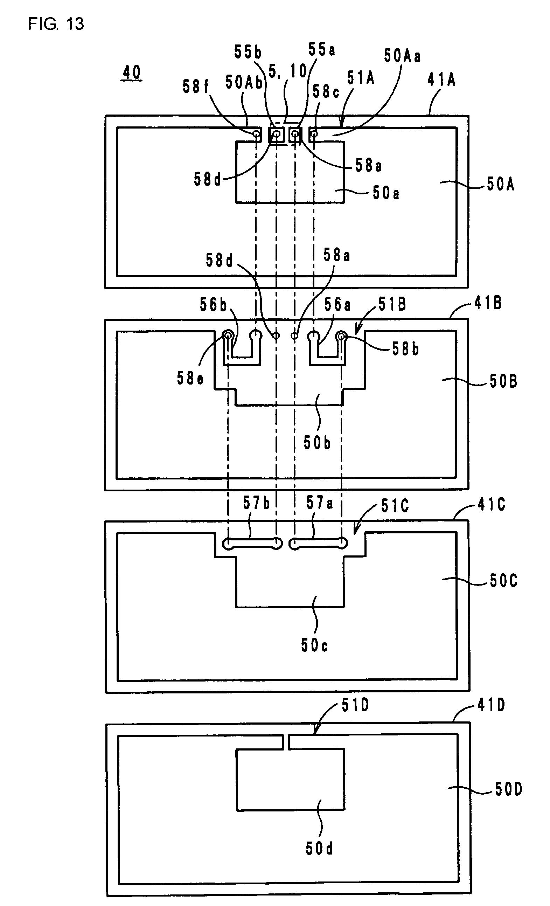

### (Twelfth Embodiment, See, Fig. 13)

Fig. 13 is an exploded view of the printed circuit board 40 included in a radio frequency IC device according to the twelfth embodiment of the present invention. Like a printed circuit board described in the eighth embodiment (see, Fig. 9), the printed circuit board 40 is a multilayer board in which plurality of dielectric layers or a plurality of magnetic layers are laminated. The loop electrodes 51A to 51D are formed on the first layer 41A serving as the surface of the printed circuit board 40, the second layer 41B, the third layer 41C, and the fourth layer 41D serving as the undersurface of the printed circuit board 40, respectively.

The loop electrodes 51A to 51D are obtained by forming the cutouts 50a to 50d at the ground electrodes 50A to 50D formed on the layers 41A to 41D, respectively. Connection electrodes 55a and 55b formed on the first layer 41A are electrically connected to one of the input-output terminal electrodes 6 of the radio frequency IC chip 5 and the other one of the input-output terminal electrodes 6, respectively, or are electromagnetically coupled to the power supply circuit board 10 (the electromagnetic coupling module 1). The ground electrodes 50A to 50D may be electrically connected to each other through via-hole conductors. An electrode functioning as an antenna may not necessarily be a ground electrode.

Furthermore, matching electrodes 56a and 56b are disposed on the inner side of the loop electrode 51B, and matching electrodes 57a and 57b are disposed on the inner side of the loop electrode 51C. The connection electrode 55a is connected to one end of the matching electrode 57a through a via-hole conductor 58a, and the other end of the matching electrode 57a is connected to one end of the matching electrode 56a through a via-hole conductor 58b. The other end of the matching electrode 56a is connected to an end 50Aa of the ground electrode 50A through a via-hole conductor 58c. The connection electrode 55b is connected to one end of the matching electrode 57b through a via-hole conductor 58d, and the other end of the matching electrode 57b is connected to one end of a matching electrode 56b through a via-hole conductor 58e. The other end of the matching electrode 56b is connected to an end 50Ab of the ground electrode 50A through a via-hole conductor 58f.

Like the above-described embodiments, in the twelfth embodiment, the ground electrode 50A functions as an antenna, and provides the same operational effect as that described in the first embodiment. Furthermore, the length of a path for a current passing through the loop electrode 51A is increased by the matching electrodes 56a and 56b, which are disposed on the inner side of the loop electrode 51B, and the matching electrodes 57a and 57b, which are disposed on the inner side of the loop electrode 51C. The resistance and the real part are therefore increased. As a result, the impedance (Z) can be increased. In the twelfth embodiment, since the matching electrodes 56a, 56b, 57a, and 57b are included in a laminated structure, the length of a path for a current can be increased even in a small apparatus and a relatively high impedance (Z) can be obtained.

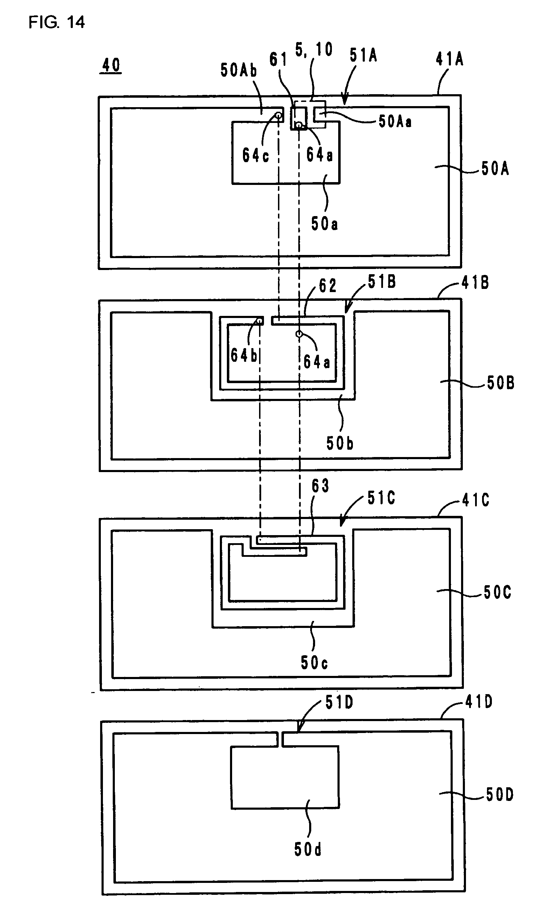

### (Thirteenth Embodiment, See, Fig. 14)

Fig. 14 is an exploded view of the printed circuit board 40 included in a radio frequency IC device according to the thirteenth embodiment of the present invention. Like the printed circuit board described in the eighth and twelfth embodiments, the printed circuit board 40 is a multilayer board in which a plurality of dielectric layers or a plurality of magnetic layers are laminated. The loop electrodes 51A to 51D are formed on the first layer 41A serving as the surface of the printed circuit board 40, the second layer 41B, the third layer 41C, and the fourth layer 41D serving as the undersurface of the printed circuit board 40, respectively.

The loop electrodes 51A to 51D are obtained by forming the cutouts 50a to 50d at ground electrodes 50A to 50D formed on the layers 41A to 41D, respectively. A connection electrode 61 formed on the first layer 41A and the end 50Aa of the ground electrode 50A are electrically connected to one of the input-output terminal electrodes 6 of the radio frequency IC chip 5 and the other one of the input-output terminal electrodes 6, respectively, or are electromagnetically coupled to the power supply circuit board 10 (the electromagnetic coupling module 1). The ground electrodes 50A to 50D may be electrically connected to each other through via-hole conductors. An electrode functioning as an antenna may not necessarily be a ground electrode.

Furthermore, matching electrodes 62 and 63 are disposed on the inner sides of the loop electrode 51B and 51c, respectively. The connection electrode 61 is connected to one end of the matching electrode 63 through a via-hole conductor 64a, and the other end of the matching electrode 63 is connected to one end of the matching electrode 62 through a via-hole conductor 64b. The other end of the matching electrode 62 is connected to the end 50Ab of the ground electrode 50A through a via-hole conductor 64c.

Like the above-described embodiments, in the thirteenth embodiment, the ground electrode 50A functions as an antenna, and provides the same operational effect as that described in the first embodiment. Furthermore, the length of a path for a current passing through the loop electrode 51A is increased by the matching electrodes 62 and 63 which are disposed on the inner sides of the loop electrodes 51B and 51C, respectively. The resistance and the real part are therefore increased. As a result, the impedance (Z) can be increased. Like the twelfth embodiment, in the thirteenth embodiment, since the matching electrodes 62 and 63 are included in a laminated structure, the length of a path for a current can be increased even in a small apparatus and a relatively high impedance (Z) can be obtained.

### (First Example of Resonance Circuit, See, Fig. 15)

Fig. 15 is a diagram illustrating a first example of a resonance circuit included in the power supply circuit board 10. The power supply circuit board 10 is obtained by laminating, press-bonding, and firing ceramic sheets 11A to 11H each made of a dielectric material. On the sheet 11A, the connection electrodes 12a and 12b, the electrodes 12c and 12d, and via-hole conductors 13a and 13b are formed. On the sheet 11B, a capacitor electrode 18a, conductor patterns 15a and 15b, and via-hole conductors 13c to 13e are formed. On the sheet 11C, a capacitor electrode 18b, the via-hole conductors 13d and 13e, and a via-hole conductor 13f are formed. On the sheet 11D, conductor patterns 16a and 16b, the via-hole conductors 13e and 13f, and via-hole conductors 14a, 14b, and 14d are formed. On the sheet 11E, the conductor patterns 16a and 16b, the via-hole conductors 13e, 13f, and 14a, and via-hole conductors 14c and 14e are formed. On the sheet 11F, a capacitor electrode 17, the conductor patterns 16a and 16b, the via-hole conductors 13e and 13f, and via-hole conductors 14f and 14g are formed. On the sheet 11G, the conductor patterns 16a and 16b and the via-hole conductors 13e, 13f, 14f, and 14g are formed. On the sheet 11H, the conductor patterns 16a and 16b and the via-hole conductor 13f are formed.

By laminating the sheets 11A to 11H, an inductance element L1, an inductance element L2, a capacitance element C1, and a capacitance element C2 are formed. The inductance element L1 is composed of the conductor patterns 16a that are helically connected by the via-hole conductors 14c, 14d, and 14g. The inductance element L2 is composed of the conductor patterns 16b that are helically connected by the via-hole conductors 14b, 14e, and 14f. The capacitance element C1 is composed of the capacitor electrodes 18a and 18b. The capacitance element C2 is composed of the capacitor electrodes 18b and 17.

One end of the inductance element L1 is connected to the capacitor electrode 18b through the via-hole conductor 13d, the conductor pattern 15a, and the via-hole conductor 13c. One end of the inductance element L2 is connected to the capacitor electrode 17 through the via-hole conductor 14a. The other ends of the inductance elements L1 and L2 are combined on the sheet 11H, and are then connected to the connection electrode 12a through the via-hole conductor 13e, the conductor pattern 15b, and the via-hole conductor 13a. The capacitor electrode 18a is electrically connected to the connection electrode 12b through the via-hole conductor 13b.

The connection electrodes 12a and 12b are electrically connected via the metal bump 8 to one of the terminal electrodes 6 of the radio frequency IC chip 5 and the other one of the terminal electrodes 6, respectively. The electrodes 12c and 12d are connected to one of the terminal electrodes 7 of the radio frequency IC chip 5 and the other one of the terminal electrodes 7, respectively.

On the undersurface of the power supply circuit board 10, the outer electrodes 19a and 19b are disposed by applying coating of conductive paste thereto. The outer electrode 19a is coupled to the inductance element L (L1 and L2) by magnetic field coupling. The outer electrode 19b is electrically connected to the capacitor electrode 18b through the via-hole conductor 13f. As described previously, the outer electrodes 19a and 19b are electrically connected to the connection electrodes 35a and 35b of the loop electrode 35, respectively, or are electrically connected to the connection electrodes 36a and 36b of the loop electrode 36, respectively.

In this resonance circuit, the inductance elements L1 and L2 are obtained by the parallel arrangement of two conductor patterns, that is, the conductor patterns 16a and 16b. Since the line lengths of the conductor patterns 16a and 16b are different from each other, they have different resonance frequencies. Accordingly, the wider frequency band of a radio frequency IC device can be achieved.

Each of the ceramic sheets 11A to 11H may be a ceramic sheet made of a magnetic material. In this case, the power supply circuit board 10 can be easily obtained by employing a multilayer board manufacturing process including a sheet lamination method and a thick film printing method which have been used.

Each of the sheets 11A to 11H may be a flexible sheet made of a dielectric material such as polyimide or liquid crystal polymer. In this case, the inductance elements L1 and L2 and the capacitance elements C1 and C2 may be included in a laminate obtained by forming an electrode and a conductor on each of the flexible sheets using a thick film formation method and laminating these sheets by thermocompression bonding.

In the power supply circuit board 10, the inductance elements L1 and L2 and the capacitance elements C1 and C2 are disposed at different positions in a perspective plan view. The inductance elements L1 and L2 are coupled to the outer electrode 19a by magnetic field coupling. The outer electrode 19b functions as one of electrodes of the capacitance element C1.

Accordingly, in the electromagnetic coupling module 1 in which the radio frequency IC chip 5 is mounted on the power supply circuit board 10, the ground electrode 21 receives high-frequency signals (for example, UHF signals) emitted from a reader/writer (not illustrated). The electromagnetic coupling module 1 causes a resonance circuit, which is coupled to the outer electrodes 19a and 19b by magnetic field coupling and electric field coupling, to resonate via the loop electrode 35 or 36 so as to supply only a received signal that falls within a predetermined frequency range to the radio frequency IC chip 5. On the other hand, predetermined energy is extracted from the received signal, and is then used to cause the resonance circuit to match the frequency of information stored in the radio frequency IC chip 5 to a predetermined frequency and then transmit the information to the ground electrode 21 via the outer electrodes 19a and 19b and the loop electrode 35 or 36. The ground electrode 21 transmits or transfers the information to the reader/writer.

In the power supply circuit board 10, a resonance frequency characteristic is determined by a resonance circuit including the inductance elements L1 and L2 and the capacitance elements C1 and C2. The resonance frequency of a signal emitted from the ground electrode 21 is practically determined on the basis of the self-resonance frequency of the resonance circuit.

The resonance circuit also functions as a matching circuit for performing the impedance matching between the radio frequency IC chip 5 and the ground electrode 21. The power supply circuit board 10 may include a matching circuit separately from a resonance circuit including an inductance element and a capacitance element (in this sense, a resonance circuit is also referred to as a matching circuit). If a matching circuit function is added to a resonance circuit, the design of the resonance circuit becomes complicated. If a matching circuit is disposed separately from a resonance circuit, they can be separately designed. The loop electrodes 35 and 36 may have an impedance matching function or a resonance circuit function. In this case, by performing the design of a resonance circuit (matching circuit) included in the power supply circuit board 10 in consideration of the shape of a loop electrode and the size of a ground electrode functioning as a radiation plate, a radiation characteristic can be improved.

### (Second Example of Resonance Circuit, See, Fig. 16)

Fig. 16 is a diagram illustrating a second example of a resonance circuit included in a power supply circuit board 70. The power supply circuit board 70 is a flexible PET film on which a helical conductor pattern 72 functioning as an inductance element L and a capacitor electrode 73 functioning as a capacitance element C are formed. The electrodes 12a and 12b extracted from the conductor pattern 72 and the capacitor electrode 73 are electrically connected to one of the terminal electrodes 6 of the radio frequency IC chip 5 and the other one of the terminal electrodes 6, respectively. The electrodes 12c and 12d formed on the power supply circuit board 70 are electrically connected to one of the terminal electrodes 7 of the radio frequency IC chip 5 and the other one of the terminal electrodes 7, respectively.

Like the above-described first example of a resonance circuit, a resonance circuit included in the power supply circuit board 70 is composed of the inductance element L and the capacitance element C, and is coupled to the electrode 35a or 36a facing the inductance element L by magnetic field coupling and the electrode 35b or 36b facing the capacitance element C by electric field coupling. In this second example, since the power supply circuit board 70 is formed from a flexible film, the height of the electromagnetic coupling module 1 is reduced. In the inductance element L, a resonance frequency can be adjusted by changing an inductance value. The inductance value can be changed by changing the line width or line space of the conductor pattern 72.

Like the first example, in the second example, the inductance element L is obtained by helically arranging two conductor patterns, that is, the conductor patterns 72, and connecting them at the center portion of the helical structure. The conductor patterns 72 have different inductance values L1 and L2. Accordingly, like the first example, since the resonance frequencies of the conductor patterns 72 can be different from each other, the wider usable frequency band of a radio frequency IC device can be achieved.

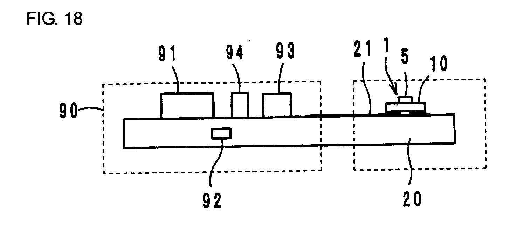

### (Electronic Apparatus, See, Figs. 17 and 18)

Next, a mobile telephone will be described as an electronic apparatus according to an embodiment of the present invention. A mobile telephone 80 illustrated in Fig. 17 is adaptable to a plurality of frequencies. Various signals such as a terrestrial digital signal, a GPS signal, a WiFi signal, a CDMA communication signal, and a GSM communication signal are input into the mobile telephone 80.

As illustrated in Fig. 18, in a casing 81, the printed circuit board 20 is disposed. At the printed circuit board 20, a radio communication circuit 90 and the electromagnetic coupling module 1 are disposed. The radio communication circuit 90 includes an IC 91, a balun 92 included in the printed circuit board 20, a BPF 93, and a capacitor 94. The power supply circuit board 10 on which the radio frequency IC chip 5 is mounted is disposed on a loop electrode (for example, the loop electrode 35 described in the sixth embodiment or the loop electrode 36 described in the seventh embodiment) coupled to the ground electrode 21 formed on the printed circuit board 20, whereby a radio frequency IC device is formed.

### (Other Embodiments)

A radio frequency IC device according to the present invention and an electronic apparatus according to the present invention are not limited to the above-described embodiments, and various changes can be made to the present invention without departing from the spirit and scope of the present invention.

For example, as an electrode for transmitting and receiving a high-frequency signal, not only a ground electrode but also various electrodes disposed at a circuit board can be used. Furthermore, various types of resonance circuits can be used. A material for each of the outer electrode and the power supply circuit board which have been described in the above-described embodiments is an example only. Any material satisfying the requirement of a characteristic can be used. A power supply circuit board may also have a radio frequency IC function so as to form a radio frequency IC and a power supply circuit on a single substrate. In this case, the size and profile of a radio frequency IC device can be reduced.

In the first to fifth embodiments, instead of a radio frequency IC chip, the electromagnetic coupling module 1 described in the sixth and seventh embodiments may be used.

In order to mount a radio frequency IC chip on a power supply circuit board, another method other than a method using a metal bump may be used. A dielectric may be disposed between the electrode of a radio frequency IC chip and the connection electrode of a power supply circuit board so as to achieve the capacitive coupling between these electrodes. Furthermore, the capacitive coupling between a radio frequency IC chip and a loop electrode or between a power supply circuit board and a loop electrode may be achieved.

An apparatus containing a radio frequency IC device is not limited to a radio frequency communication apparatus such as a mobile telephone. Various apparatuses each provided with a circuit board including a ground electrode (for example, home electric appliances such as a television set and a refrigerator) may be used.

### Industrial Applicability

As described previously, the present invention is useful for a radio frequency IC device including a radio frequency IC chip and an electronic apparatus including the radio frequency IC device, and, in particular, has an advantage in its suitability for achieving size reduction and easily achieving impedance matching without a dedicated antenna.

## Claims

1. An electronic apparatus comprising a radio frequency IC device, the radio frequency IC device comprising:
a radio frequency IC chip (5) for processing a transmission/received signal;
a printed circuit board (20) on which the radio frequency IC chip (5) is mounted;
a ground electrode (21; 50A-50D) used for another electronic component in the electronic apparatus and formed at the printed circuit board (20); and
a loop electrode (22; 25; 31; 32; 51A-51D) that is formed at the printed circuit board (20) so that the loop electrode (22; 25; 31; 32; 51A-51D) is coupled to the radio frequency IC chip (5) and the ground electrode (21; 50A-50D),
wherein the ground electrode (21; 50A-50D) is arranged to function as a radiation plate, wherein the ground electrode (21; 50A-50D) is arranged to receive a signal from the outside, wherein the radio frequency IC chip (5) is arranged to receive the signal from the ground electrode (21; 50A-50D) via the loop electrode (22; 25; 31; 32; 51A-51D) and to be operated by the received signal, wherein the loop electrode (22; 25; 31; 32; 51A-51D) is arranged to transmit a response signal from the radio frequency IC chip (5) to the ground electrode (21; 50A-50D), and wherein the ground electrode (21; 50A-50D) is arranged to emit the response signal to the outside.

2. The electronic apparatus according to claim 1, wherein the radio frequency IC device comprises an electromagnetic coupling module including the radio frequency IC chip (5) for processing a transmission/received signal and a power supply circuit board (10) that includes an inductance element coupled to the radio freyuency IC chip (5).

3. The electronic apparatus according to Claim 2, wherein a resonance circuit is formed in the power supply circuit board (10).

4. The electronic apparatus according to Claim 2 or 3, wherein a matching circuit is formed in the power supply circuit board (10).

5. The electronic apparatus according to any one of Claims 1 to 4, wherein the loop electrode (22; 31; 35; 36; 51A-51D) and the ground electrode formed at the printed circuit board (20) are formed on the same main surface of the printed circuit board (20).

6. The electronic apparatus according to any one of Claims 1 to 4, wherein at least one of the loop electrode (25; 32) and the ground electrode formed at the printed circuit board (20) is formed in the printed circuit board (20).

7. The electronic apparatus according to any one of Claims 1 to 6, wherein the loop electrode (22; 25; 35) and the ground electrode formed at the printed circuit board (20) are electrically isolated from each other.

8. The electronic apparatus according to any one of Claims 1 to 6, wherein the loop electrode (31; 32; 36; 51A-51D) and the ground electrode formed at the printed circuit board (20) are electrically connected to each other.

9. The electronic apparatus according to any one of Claims 1 to 8, wherein the printed circuit board (20) is a multilayer board in which a plurality of dielectric layers or a plurality of magnetic layers are laminated.

10. The electronic apparatus according to any one of Claims 1 to 9, wherein the loop electrode (22; 25; 31; 32; 35; 36; 51A-51D) has an impedance matching function.

11. The electronic apparatus according to Claim 9 or 10, wherein the loop electrode is formed on a main surface of the printed circuit board (20) and is formed on at least one dielectric layer or on at least one magnetic layer.

12. The electronic apparatus according to any one of Claims 9 to 11, wherein the loop electrode (51A-51D) is formed on a plurality of layers, and the loop electrode formed on at least one of the plurality of layers is different from the loop electrodes formed on the other ones of the plurality of layers in loop size.

13. The electronic apparatus according to Claim 12, wherein end portions of the loop electrode that is different from the loop electrodes in loop size are coupled to the radio frequency IC chip (5) or the electromagnetic coupling module.

14. The electronic apparatus according to any one of Claims 1 to 13, wherein a matching electrode (37; 56a, 56b, 57a, 57b; 62, 63) is disposed on the inner side of the loop electrode (31; 51A-51D)).

15. The electronic apparatus according to any one of Claims 2 to 14, wherein an outer electrode is formed on a surface of the power supply circuit board (10), the outer electrode being coupled to the resonance circuit and/or the matching circuit by electromagnetic field coupling and being electrically connected to the loop electrode.

16. The electronic apparatus according to any one of Claims 2 to 15, wherein the power supply circuit board (10) is a multilayer board.

17. The electronic apparatus according to any one of Claims 2 to 15, wherein the power supply circuit board (10) is a flexible board.

## Patentansprüche

1. Eine elektronische Vorrichtung, die ein Hochfrequenz-IC-Bauelement aufweist, wobei das Hochfrequenz-IC-Bauelement folgende Merkmale aufweist:
einen Hochfrequenz-IC-Chip (5) zum Verarbeiten eines Sende-/Empfangssignals;
eine gedruckte Schaltungsplatine (20), auf der der Hochfrequenz-IC-Chip (5) befestigt ist;
eine Masseelektrode (21; 50A-50D), die für eine andere elektronische Komponente in der elektronischen Vorrichtung verwendet wird und an der gedruckten Schaltungsplatine (20) gebildet ist; und
eine Schleifenelektrode (22; 25; 31; 32; 51A-51D), die an der gedruckten Schaltungsplatine (20) gebildet ist, so dass die Schleifenelektrode (22; 25; 31; 32; 51A-51D) mit dem Hochfrequenz-IC-Chip (5) und der Masseelektrode (21; 50A-50D) gekoppelt ist,
wobei die Masseelektrode (21; 50A-50D) angeordnet ist, um als eine Strahlungsplatte zu wirken, wobei die Masseelektrode (21; 50A-50D) angeordnet ist, um ein Signal von außen zu empfangen, wobei der Hochfrequenz-IC-Chip (5) angeordnet ist, um das Signal von der Masseelektrode (21; 50A-50D) über die Schleifenelektrode (22; 25; 31; 32; 51A-51D) zu empfangen und durch das empfangene Signal betrieben zu werden, wobei die Schleifenelektrode (22; 25; 31; 32; 51A-51D) angeordnet ist, um ein Antwortsignal von dem Hochfrequenz-IC-Chip (5) an die Masseelektrode (21; 50A-50D) zu senden, und wobei die Masseelektrode (21; 50A-50D) angeordnet ist, um das Antwortsignal nach außen zu emittieren.

2. Die elektronische Vorrichtung gemäß Anspruch 1, bei der das Hochfrequenz-IC-Bauelement ein elektromagnetisches Kopplungsmodul aufweist, das den Hochfrequenz-IC-Chip (5) zum Verarbeiten eines Sende-/Empfangssignals und eine Leistungsversorgungsschaltungsplatine (10) umfasst, die ein Induktivitätselement umfasst, das mit dem Hochfrequenz-IC-Chip (5) gekoppelt ist.

3. Die elektronische Vorrichtung gemäß Anspruch 2, bei der eine Resonanzschaltung in der Leistungsversorgungsschaltungsplatine (10) gebildet ist.

4. Die elektronische Vorrichtung gemäß Anspruch 2 oder 3, bei der eine Anpassungsschaltung in der Leistungsversorgungsschaltungsplatine (10) gebildet ist.

5. Die elektronische Vorrichtung gemäß einem der Ansprüche 1 bis 4, bei der die Schleifenelektrode (22; 31; 35; 36; 51A-51D) und die Masseelektrode, die an der gedruckten Schaltungsplatine (20) gebildet sind, auf derselben Hauptoberfläche der gedruckten Schaltungsplatine (20) gebildet sind.

6. Die elektronische Vorrichtung gemäß einem der Ansprüche 1 bis 4, bei der zumindest eine der Schleifenelektrode (25; 32) und der Masseelektrode, die an der gedruckten Schaltungsplatine (20) gebildet sind, in der gedruckten Schaltungsplatine (20) gebildet ist.

7. Die elektronische Vorrichtung gemäß einem der Ansprüche 1 bis 6, bei der die Schleifenelektrode (22; 25; 35) und die Masseelektrode, die an der gedruckten Schaltungsplatine (20) gebildet sind, elektrisch voneinander isoliert sind.

8. Die elektronische Vorrichtung gemäß einem der Ansprüche 1 bis 6, bei der die Schleifenelektrode (31; 32; 36; 51A-51D) und die Masseelektrode, die an der gedruckten Schaltungsplatine (20) gebildet sind, elektrisch miteinander verbunden sind.

9. Die elektronische Vorrichtung gemäß einem der Ansprüche 1 bis 8, bei der die gedruckte Schaltungsplatine (20) eine Mehrschichtplatine ist, bei der eine Mehrzahl von dielektrischen Schichten oder eine Mehrzahl von magnetischen Schichten laminiert sind.

10. Die elektronische Vorrichtung gemäß einem der Ansprüche 1 bis 9, bei der die Schleifenelektrode (22; 25; 31; 32; 35; 36; 51A-51D) eine Impedanzanpassungsfunktion aufweist.

11. Die elektronische Vorrichtung gemäß Anspruch 9 oder 10, bei der die Schleifenelektrode auf einer Hauptoberfläche der gedruckten Schaltungsplatine (20) gebildet ist und auf zumindest einer dielektrischen Schicht oder auf zumindest einer magnetischen Schicht gebildet ist.

12. Die elektronische Vorrichtung gemäß einem der Ansprüche 9 bis 11, bei der die Schleifenelektrode (51 A-51 D) auf einer Mehrzahl von Schichten gebildet ist und sich die Schleifenelektrode, die auf zumindest einer der Mehrzahl von Schichten gebildet ist, von den Schleifenelektroden, die auf den anderen der Mehrzahl von Schichten gebildet sind, in einer Schleifengröße unterscheidet.

13. Die elektronische Vorrichtung gemäß Anspruch 12, bei der Endabschnitte der Schleifenelektrode, die sich von den Schleifenelektroden in einer Schleifengröße unterscheidet, mit dem Hochfrequenz-IC-Chip (5) oder dem elektromagnetischen Kopplungsmodul gekoppelt sind.

14. Die elektronische Vorrichtung gemäß einem der Ansprüche 1 bis 13, bei der eine Anpassungselektrode (37; 56a, 56b, 57a, 57b; 62, 63) auf der Innenseite der Schleifenelektrode (31; 51 A-51 D) angeordnet ist.

15. Die elektronische Vorrichtung gemäß einem der Ansprüche 2 bis 14, bei der eine Außenelektrode auf einer Oberfläche der Leistungsversorgungsschaltungsplatine (10) gebildet ist, wobei die Außenelektrode durch elektromagnetische Feldkopplung mit der Resonanzschaltung und/oder der Anpassungsschaltung gekoppelt ist und mit der Schleifenelektrode elektrisch verbunden ist.

16. Die elektronische Vorrichtung gemäß einem der Ansprüche 2 bis 15, bei der die Leistungsversorgungsschaltungsplatine (10) eine Mehrschichtplatine ist.

17. Die elektronische Vorrichtung gemäß einem der Ansprüche 2 bis 15, bei der die Leistungsversorgungsschaltungsplatine (10) eine flexible Platine ist.

## Revendications

1. Appareil électronique qui comprend un dispositif à circuit imprimé radiofréquence, le dispositif à circuit imprimé radiofréquence comprenant :
une puce de circuit imprimé radiofréquence (5) destinée à traiter un signal transmis/reçu ;
une carte de circuit imprimé (20) sur laquelle est montée la puce de circuit imprimé radiofréquence (5) ;
une électrode de masse (21 ; 50A-50D) utilisée pour un autre composant électronique dans l'appareil électronique, et formée au niveau de la carte de circuit imprimé (20) ; et
une électrode en boucle (22 ; 25 ; 31 ; 32 ; 51A-51D) qui est formée au niveau de la carte de circuit imprimé (20) de sorte que l'électrode en boucle (22 ; 25 ; 31 ; 32 ; 51A-51D) soit reliée à la puce de circuit imprimé radiofréquence (5) et à l'électrode de masse (21 ; 50A-50D),
dans lequel l'électrode de masse (21 ; 50A-50D) est prévue pour fonctionner comme une plaque de rayonnement, l'électrode de masse (21 ; 50A-50D) est prévue pour recevoir un signal de la part de l'extérieur, la puce de circuit imprimé radiofréquence (5) est prévue pour recevoir le signal de la part de l'électrode de masse (21 ; 50A-50D) par le biais de l'électrode en boucle (22 ; 25 ; 31 ; 32 ; 51A-51D) et pour être actionnée par le signal reçu, l'électrode en boucle (22 ; 25 ; 31 ; 32 ; 51A-51D) est prévue pour transmettre un signal de réponse entre la puce de circuit imprimé radiofréquence (5) et l'électrode de masse (21 ; 50A-50D), et l'électrode de masse (21 ; 50A-50D) est prévue pour émettre le signal de réponse vers l'extérieur.

2. Appareil électronique selon la revendication 1, dans lequel le dispositif à circuit imprimé radiofréquence comprend un module de couplage électromagnétique qui comprend la puce de circuit intégré radiofréquence (5) destinée à traiter un signal transmis/reçu, et une carte de circuit d'alimentation (10) qui comprend un élément d'inductance relié à la puce de circuit intégré radiofréquence (5).

3. Appareil électronique selon la revendication 2, dans lequel un circuit de résonance est formé dans la carte de circuit d'alimentation (10).

4. Appareil électronique selon la revendication 2 ou 3, dans lequel un circuit d'adaptation est formé dans la carte de circuit d'alimentation (10).

5. Appareil électronique selon l'une quelconque des revendications 1 à 4, dans lequel l'électrode en boucle (22 ; 25 ; 31 ; 32 ; 51A-51D) et l'électrode de masse formées au niveau de la carte de circuit imprimé (20) sont formées sur la même surface principale de la carte de circuit imprimé (20).

6. Appareil électronique selon l'une quelconque des revendications 1 à 4, dans lequel au moins l'une de l'électrode en boucle (25 ; 32) et de l'électrode de masse formées au niveau de la carte de circuit imprimé (20) est formée dans la carte de circuit imprimé (20).

7. Appareil électronique selon l'une quelconque des revendications 1 à 6, dans lequel l'électrode en boucle (22 ; 25 ; 35) et l'électrode de masse formées au niveau de la carte de circuit imprimé (20) sont isolées électriquement l'une de l'autre.

8. Appareil électronique selon l'une quelconque des revendications 1 à 6, dans lequel l'électrode en boucle (31 ; 32 ; 36 ; 51A-51D) et l'électrode de masse formées au niveau de la carte de circuit imprimé (20) sont électriquement reliées l'une à l'autre.

9. Appareil électronique selon l'une quelconque des revendications 1 à 8, dans lequel la carte de circuit imprimé (20) est une carte à plusieurs couches dans laquelle plusieurs couches diélectriques ou plusieurs couches magnétiques sont stratifiées.

10. Appareil électronique selon l'une quelconque des revendications 1 à 9, dans lequel l'électrode en boucle (22 ; 25 ; 31 ; 32 ; 35 ; 36 ; 51A-51D) possède une fonction d'adaptation d'impédance.

11. Appareil électronique selon la revendication 9 ou 10, dans laquelle l'électrode en boucle est formée sur une surface principale de la carte de circuit imprimé (20), et est formée sur au moins une couche diélectrique ou sur au moins une couche magnétique.

12. Appareil électronique selon l'une quelconque des revendications 9 à 11, dans lequel l'électrode en boucle (51A-51D) est formée sur une pluralité de couches, et l'électrode en boucle formée sur au moins l'une de la pluralité de couches est différente des électrodes en boucle formées sur les autres de la pluralité de couches en forme de boucle.

13. Appareil électronique selon la revendication 12, dans lequel les parties d'extrémité de l'électrode en boucle qui est différente des électrodes en boucle en forme de boucle sont reliées à la puce de circuit imprimé radiofréquence (5) ou au module de couplage électromagnétique.

14. Appareil électronique selon l'une quelconque des revendications 1 à 13, dans lequel une électrode d'adaptation (37 ; 56a, 56b, 57a, 57b ; 62, 63) est disposée sur un côté intérieur de l'électrode en boucle (31 ; 51A-51D).

15. Appareil électronique selon l'une quelconque des revendications 2 à 14, dans lequel une électrode extérieure est formée sur une surface de la carte de circuit d'alimentation (10), l'électrode extérieure étant reliée au circuit de résonance et/ou au circuit d'adaptation par le couplage de champ électromagnétique, et étant reliée électriquement à l'électrode en boucle.

16. Appareil électronique selon l'une quelconque des revendications 2 à 15, dans lequel la carte de circuit d'alimentation (10) est une carte à plusieurs couches.

17. Appareil électronique selon l'une quelconque des revendications 2 à 15, dans lequel la carte de circuit d'alimentation (10) est une carte flexible.
